# DEMANDE DE BREVET EUROPEEN

(11) **EP 2 955 983 A1**
(43) Date de publication de la demande: **16.12.2015**
(21) Numéro de dépôt: 15178707.4
(22) Date de dépôt: 31.08.2012
(51) Int. Cl.: H05K 7/14, H05K 7/20

(54) **ORGANE DE PLAQUAGE D'UNE PIECE SUR UNE SURFACE**

(30) Priorité: 12.09.2011 FR 1158090
(62) Demande divisionnaire de: 12762346.0
(71) Demandeur: Valeo Systèmes de Contrôle Moteur, 95892 Cergy Pontoise (FR)
(72) Inventeur: TRAMET, Guillaume, 78360 MONTESSON (FR); HERAULT, Fabrice, 78410 FLINS SUR SEINE (FR); MORLIERE, Benjamin, 95520 OSNY (FR)

(57) **Abrégé**

L'invention concerne un organe (200) de plaquage d'une pièce (10) sur une surface (5) d'un support (20), ledit organe comprenant un élément élastiquement déformable (22, 23) s'étendant suivant un axe, ledit élément ayant
une première extrémité destinée à être en liaison mécanique avec ledit support (20), et
une seconde extrémité destinée à exercer un effort sur ladite pièce (10),
ledit élément élastiquement déformable comprenant au moins un ressort (22, 23) et
l'organe de placage comprenant une tige (24) montée dans l'axe de l'élément déformable, la tige (24) étant destinée à participer à la liaison mécanique entre la première extrémité et le support (5).

## Description

La présente invention se rapporte à un organe de plaquage et à un bloc de puissance, notamment pour un onduleur, en particulier monté aux bornes d'une batterie à haute tension d'un véhicule électrique. Le bloc de puissance comporte au moins un module électronique de puissance, de préférence une pluralité de modules électroniques de puissance.

On connaît déjà dans l'art antérieur des modules de puissance destinés à faire partie d'un tel bloc de puissance, notamment des modules de puissance à Grille de connexion Moulée Isolée ou module IML (pour « Insulated Moulded Leadframe » en anglais) du brevet français N° 0116153 au nom de la demanderesse. Typiquement, le module de puissance comprend un boîtier dans lequel sont logés un ou plusieurs composants électroniques de puissance. Le bloc de puissance comprend en outre au moins une carte électronique de commande. La carte électronique de commande est typiquement une carte à circuits imprimés ou PCB (pour « printed circuit board » en anglais). Le module de puissance et la carte électronique de commande sont connectés électriquement afin d'assurer les fonctions du bloc de puissance. Typiquement, le module et la carte sont logés dans un carter du bloc de puissance.

En fonctionnement, le chauffage intempestif des modules électroniques de puissance nuit à leur fiabilité et entraîne des dommages, notamment sur leurs composants de puissance, provoquant un effet néfaste sur la durée de vie du bloc de puissance. Afin d'évacuer la chaleur formée dans le boîtier du module électronique de puissance, il est connu de presser ou plaquer le module électronique de puissance contre un fond du carter et de choisir les matériaux du fond du boîtier du module électronique de puissance et du fond du carter de sorte qu'ils soient compatibles en terme de conductivité thermique. Typiquement, un fluide de refroidissement est en contact avec le fond du carter. Ainsi, la chaleur formée dans le boîtier est évacuée par le fond du boîtier et le fond du carter avant que celle-ci ne vienne détériorer les composants électroniques de puissance. La durée de vie du bloc de puissance en est fortement améliorée.

Afin de plaquer le module contre le fond du carter, il est connu d'intégrer des pattes de fixation au boîtier du module. Typiquement des vis sont insérées dans des oeillets des pattes pour fixer et plaquer le module de puissance contre le fond du carter. Cependant, ces vis subissent une usure au cours du temps, notamment due aux vibrations du bloc de puissance lorsqu'il est monté dans un véhicule. Sous l'effet des vibrations, la masse du module de puissance exerce un effort d'arrachement sur les vis, ce qui entraîne une dégradation du filetage des vis. Ainsi, l'effort de plaquage exercé sur le module de puissance diminue. Le module de puissance est alors moins bien plaqué sur le fond du carter, ce qui réduit la dissipation thermique par le fond du carter.

Il est recherché un moyen de plaquage de un ou plusieurs modules de puissance améliorant la tenue du plaquage dans le temps.

La présente invention vise à surmonter les inconvénients de l'art antérieur en proposant un organe de plaquage d'une pièce sur une surface d'appui d'un support, ledit organe comprenant un élément élastiquement déformable s'étendant suivant un axe, ledit élément ayant
une première extrémité destinée à être en liaison mécanique avec ledit support, et
une seconde extrémité destinée à exercer un effort sur ladite pièce.

La liaison mécanique entre la première extrémité et le support permet de fixer la première extrémité de l'élément déformable au support. La première extrémité peut être solidaire au support directement ou par l'intermédiaire d'éléments situés entre la première extrémité et le support.

Dans le cadre de la présente demande, par élément élastiquement déformable on entend un élément qui revient à une position initiale en l'absence de contrainte. L'élément élastiquement déformable exerce un effort sur la pièce pour la maintenir en contact avec la surface d'appui. Dans l'art antérieur, l'appui de la pièce sur la surface est réalisé par la mise en prise d'une vis. Dans l'organe selon l'invention, l'appui de la pièce sur la surface est réalisé par l'élément élastiquement déformable via sa seconde extrémité. Ainsi, les vibrations, notamment dans une direction orthogonale à la surface d'appui, subies par la pièce sont absorbées par l'élément déformable. L'élément élastique n'étant pas sensible à des contraintes d'arrachement, la pièce est donc plaquée contre la surface d'appui de façon durable.

Notamment, l'axe de l'élément déformable peut être suivant une direction transversale à la surface d'appui, et l'organe de plaquage appuie sur la pièce suivant une direction transverse à la surface d'appui.

Suivant un mode de réalisation de l'invention, l'élément élastiquement déformable comprend au moins un ressort.

Suivant un mode de réalisation de l'invention, l'élément élastiquement déformable comprend deux ressorts coaxiaux de fréquences de résonance différentes.

Si un ressort entre en résonance, l'autre ressort est à même de conserver un fonctionnement normal et de maintenir le plaquage de la pièce contre la surface d'appui. Ainsi, la robustesse de l'organe de plaquage est améliorée.

Suivant un mode de réalisation de l'invention, l'organe de plaquage comprend en outre une tige montée dans l'axe de l'élément déformable, la tige étant destinée à participer à la liaison mécanique entre la première extrémité et le support.

La tige permet de fixer la première extrémité de l'élément déformable au support par l'intermédiaire de la surface d'appui. Ainsi, la liaison mécanique entre la première extrémité et le support est obtenue de façon simple.

Par exemple, la tige a une portion solidaire avec la première extrémité de l'élément déformable, et une portion destinée à venir en prise avec la surface d'appui.

Par exemple, la tige a une première portion de grand diamètre, une deuxième portion de petit diamètre et une troisième portion destinée à venir en prise avec la surface,
ladite deuxième portion étant montée dans l'axe de l'élément déformable, et
ladite première portion étant destinée à appuyer sur
la première extrémité de l'élément déformable lorsque la troisième portion vient en prise avec la surface.

Ainsi, la seconde extrémité de l'élément déformable exerce un effort sur la pièce lorsque la troisième portion vient en prise avec la surface.

Suivant un mode de réalisation, l'organe de plaquage comprend en outre une entretoise dans laquelle est montée l'élément déformable,
l'entretoise comprenant au moins une portion radiale s'étendant suivant une direction transverse à l'axe de l'élément déformable, ladite portion radiale étant destinée à être prise entre la seconde extrémité de l'élément déformable et la pièce lorsque la seconde extrémité exerce un effort sur la dite pièce. Par exemple, l'élément élastiquement déformable vient en appui sur la portion radiale lorsqu'elle exerce un effort sur ladite pièce.

L'entretoise ou fût peut avoir une portion interne vide de matière pour recevoir l'élément déformable ou la tige. L'entretoise peut s'étendre suivant un axe parallèle à l'axe de l'élément déformable. Par exemple, l'entretoise a une section transverse circulaire ou polygonale. En particulier, l'entretoise peut être en un matériau rigide.

L'entretoise permet de guider l'élément élastiquement déformable. En particulier, l'entretoise prévient des déformations de l'élément déformable suivant une direction transversale à l'axe de l'élément.

De préférence, la portion radiale de l'entretoise a une ouverture permettant le passage de la tige.

La présente invention se rapporte également à un bloc de puissance comportant un carter ayant une surface d'appui sur laquelle repose au moins un module électronique de puissance, le ou chaque module électronique de puissance comportant au moins un composant électronique de puissance, caractérisé en ce qu'il comprend
au moins un organe de plaquage selon l'invention plaquant le module de puissance sur ladite surface d'appui.

De préférence, le module électronique de puissance comporte un boîtier dans lequel sont logés le ou les composants électroniques de puissance. Par exemple, la surface d'appui est un fond du carter. En particulier, la surface d'appui peut être une surface de dissipation thermique du carter.

Selon un mode de réalisation, le bloc de puissance comprend en outre
au moins une structure en vis-à-vis du module de puissance, ladite structure étant fixée au carter du bloc de puissance, et
ladite structure étant associée audit organe de plaquage.

En particulier, la structure peut être associée à l'organe de plaquage par l'intermédiaire de la première extrémité de l'élément déformable ou de la tige de l'organe de plaquage. La structure participe à la liaison mécanique entre la première extrémité de l'élément déformable de l'organe de plaquage et le carter.

L'organe de plaquage exerce un effort sur le module de puissance à partir de la structure en vis-à-vis du module de puissance. En particulier, l'organe de plaquage exerce une pression sur le module électronique de puissance, notamment sur un boîtier du module de puissance, pour le maintenir en contact avec ladite surface d'appui du carter. Notamment, l'organe de plaquage maintient une position du module électronique 21 de puissance suivant une direction transverse à la surface d'appui. Grâce à l'organe de plaquage associé à la structure, le module de puissance est plaqué contre la surface d'appui de façon durable.

L'organe de plaquage n'est pas entre la surface d'appui et le module de puissance et est donc moins sensible à des vibrations subies par le module électronique de puissance.

Suivant un mode de réalisation de l'invention, ladite structure comprend au moins une poutre sensiblement parallèle à ladite surface d'appui et fixée au carter, et l'organe de plaquage est monté entre la poutre et le module électronique de puissance.

Cependant, la structure peut être un plan ou avoir une autre forme.

En particulier, la première extrémité de l'élément élastiquement déformable peut être maintenue par la poutre, la seconde extrémité exerçant une force mécanique sur le module de puissance, notamment sur le boîtier du module de puissance. La poutre étant maintenue fixe par le carter, l'organe de plaquage exerce un effort sur le module de puissance à partir de la poutre.

Dans ce mode de réalisation, la première extrémité de l'élément déformable de l'organe de plaquage est en liaison mécanique avec le support (ici le carter) au moins par l'intermédiaire de la poutre.

Suivant un mode de réalisation de l'invention, ladite structure est fixée au carter au niveau de parois latérales du carter. Une paroi latérale est par exemple une paroi entourant la surface d'appui. La paroi peut être sensiblement transverse par rapport à la surface d'appui.

Suivant un mode de réalisation de l'invention, le bloc de puissance comprend un organe de plaquage ayant ladite tige, et ladite structure est fixée à ladite surface d'appui du carter au moins par l'intermédiaire de la tige.

Par exemple, une portion de la tige vient en appui sur un lamage de la structure.

Ainsi, la structure est fixée au carter par l'organe de plaquage. L'agencement de la structure dans le bloc de puissance en est simplifié.

Suivant une variante de ce mode de réalisation, ladite structure repose sur au moins une butée située sur une paroi latérale du carter. Par exemple, en mettant en prise la tige dans la surface d'appui, la structure vient en appui sur la butée.

Suivant un mode de réalisation, le bloc de puissance comprend un organe de plaquage ayant ladite entretoise et ladite entretoise est solidaire avec ladite structure.

Suivant un mode de réalisation du bloc de puissance, ladite structure supporte au moins une carte électronique de commande en vis-à-vis du module électronique de puissance.

Suivant un mode de réalisation du bloc de puissance, le bloc de puissance comprend un organe de plaquage ayant ladite tige et la carte électronique de commande est fixée à la structure par l'intermédiaire de la tige.

Ainsi, l'organe de plaquage assure la fixation de la structure au carter et également le maintien de la carte électronique sur la structure. L'agencement de la structure, du module de puissance et de la carte électronique en est simplifié.

Suivant un mode de réalisation du bloc de puissance, la position du module électronique de puissance sur la surface d'appui est maintenue par au moins un organe de fixation. L'organe de fixation améliore le positionnement du module de puissance sur la surface d'appui en évitant un déplacement latéral du module sur la surface. Notamment, l'organe de fixation maintient une position du module électronique 21 de puissance suivant une direction parallèle à la surface d'appui.

Par exemple, l'organe de fixation est un pion ou un cylindre solidaire au boîtier du module de puissance, qui est inséré en force dans un trou de la surface d'appui. Par exemple, l'organe de fixation est une vis introduite dans un oeillet d'une patte de fixation du boîtier et vissée dans un trou du carter.

Suivant une variante de ce mode de réalisation du bloc de puissance, le bloc de puissance comprend un organe de plaquage ayant ladite tige et ledit organe de fixation du module électronique comprend ladite tige. Ainsi, la tige maintient également la position latérale du module de puissance sur la surface d'appui. L'agencement de la structure et du module de puissance dans le carter en est simplifié.

La présente invention se rapporte également à un onduleur pour véhicule électrique comportant un bloc de puissance suivant l'invention. L'invention concerne également un véhicule électrique comportant une batterie, notamment à haute tension, une prise pour la recharge de la batterie par un réseau électrique et un onduleur suivant l'invention monté entre la batterie et la prise.

L'invention concerne également un organe de plaquage d'une pièce sur une surface d'un support, ledit organe comprenant un élément élastiquement déformable s'étendant suivant un axe, ledit élément ayant
une première extrémité destinée à être en liaison mécanique avec ledit support, et
une seconde extrémité destinée à exercer un effort sur ladite pièce,
ledit élément élastiquement déformable comprenant au moins un ressort.

L'invention concerne en outre un organe de plaquage d'une pièce sur une surface d'un support, ledit organe comprenant un élément élastiquement déformable s'étendant suivant un axe, ledit élément ayant une première extrémité destinée à être en liaison mécanique avec ledit support, et une seconde extrémité destinée à exercer un effort sur ladite pièce,
ledit élément élastiquement déformable comprenant au moins un ressort et
l'organe de placage comprenant une tige montée dans l'axe de l'élément déformable, la tige étant destinée à participer à la liaison mécanique entre la première extrémité et le support.

Les organes de plaquage peuvent comprendre l'une quelconque des caractéristiques décrites précédemment.

A titre d'exemple, on décrit maintenant des modes de réalisation de l'invention en se rapportant aux dessins dans lesquels :
- la figure 1: est une vue en perspective d'un bloc de puissance suivant un mode de réalisation ;
- la figure 2: représente une structure et des tiges faisant partie d'un bloc de puissance selon un mode de réalisation ;
- la figure 3: est une vue en coupe sous forme schématique d'une partie d'un bloc de puissance selon un mode de réalisation ;
- la figure 4: est une vue en coupe sous forme schématique d'une partie d'un bloc suivant un autre mode de réalisation ;
- la figure 5: représente un véhicule électrique comportant un bloc suivant l'invention ;
- la Figure 6: représente un exemple de module de puissance appartenant à un bloc de puissance selon l'invention ;
- la figure 7: est une vue en coupe sous forme schématique d'une partie d'un bloc de puissance suivant un mode de réalisation ;
- la figure 8: représente un exemple d'organe de plaquage suivant un mode de réalisation.

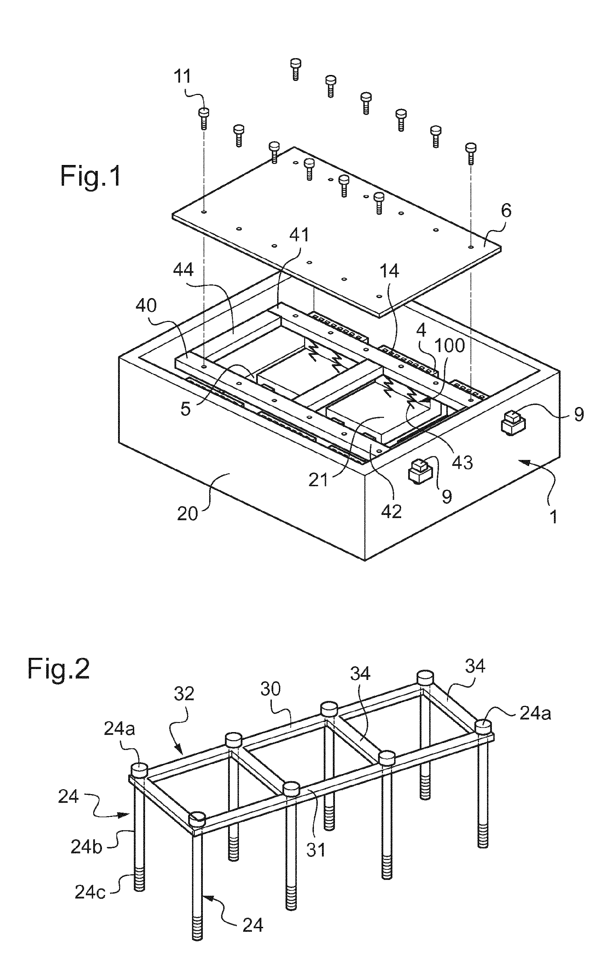

La figure 1 représente un exemple de bloc 1 de puissance selon un mode de réalisation.

Le bloc 1 de puissance comporte un carter 20 dans lequel est reçue une pluralité de modules 21 de puissance. Les modules 21 de puissance sont par exemple des modules IML. Le bloc 1 de puissance comprend notamment six modules 21 agencés suivant deux rangées de trois modules sur une surface d'appui 5.

La surface d'appui 5 est réalisée de préférence en un matériau métallique, par exemple en fonte. Par exemple, la surface d'appui 5 est un fond du carter 20. Par exemple, la surface d'appui 5 est intégrale avec des parois latérales du carter 20. La surface d'appui est par exemple une surface de dissipation thermique du carter 20.

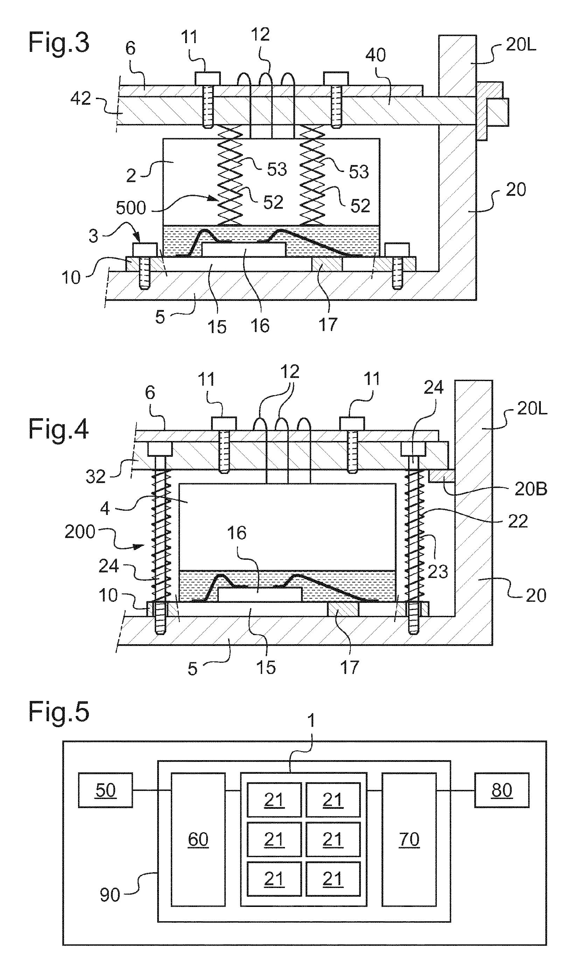

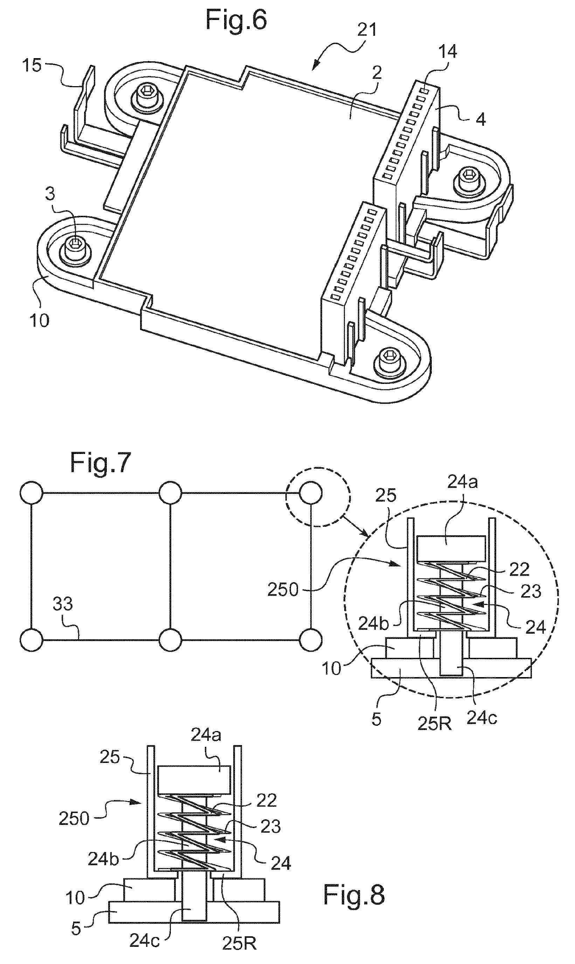

A la Figure 6, il est représenté suivant une vue en perspective un module électronique IML 21 de puissance. Le module IML 21 comprend un boîtier 2 dans lequel sont logés un ou plusieurs composants électroniques 16 de puissance (figures 3 et 4). Des plots 4 de connexion électrique font saillie sur le dessus du boîtier 2 pour assurer une connexion électrique avec une carte électronique 6 par exemple. Ces plots 4 comportent des points 14 de connexion par l'intermédiaire notamment de fils 12 de liaison électrique (« bonding » en anglais), notamment soudés par ultrasons à la carte 6 (figures 3 et 4).

L'exemple de module électronique 21 de puissance sera mieux décrit en faisant référence aux figures 3 et 4. Dans le module électronique 21 sont reçues des lames 15 conductrices, en cuivre par exemple, sur lesquelles sont montés les composants électroniques 16 de puissance. Les composants électroniques 16 de puissance peuvent être notamment des composants bipolaires tels qu'une diode, des composants tripolaires tels qu'un transistor de type MOS ou IGBT ou un composant de plus grande complexité tel qu'un circuit intégré ASIC ou analogues. Les lames 15 conductrices sont séparées les unes des autres par un matériau diélectrique dans les interstices 17 entre les lames. Par exemple, au-dessus des lames 15 conductrices et des interstices 17 de matière diélectrique isolante électriquement, le boîtier 2 est rempli d'un gel, notamment de silicone, ou d'une résine, notamment de type époxy, pour protéger les composants électroniques 16 de puissance.

Par exemple, les lames 15 conductrices font saillie à l'extérieur du boîtier 2 du module électronique 21 de puissance latéralement pour entre autres une connexion à un réseau de puissance et/ou à un module 21 voisin. Comme représenté dans les modes de réalisation des figures 3 et 4, on peut prévoir que les lames 15 conductrices et la matière diélectrique isolante électriquement dans les interstices 17 forment le fond du module électronique 21 de puissance et soient ainsi en contact avec la surface d'appui 5 du carter 20.

En vis-à-vis des modules 21 de puissance positionnés sur la surface d'appui 5 du carter 20, il peut être monté une structure 32, 33, 42 fixée au carter 20 du bloc de puissance. Dans l'exemple présenté en figure 1, la structure est un cadre 42, qui est constitué d'au moins deux poutres longitudinales 40, 41 et de poutres transversales 44 destinées à s'étendre de part et d'autre du bloc de puissance en regard des modules 21 de puissance.

La structure 32, 33, 42 est associée à au moins un organe de plaquage 100, 200, 250, 500 permettant de plaquer les modules 21 de puissance contre la surface d'appui 5.

En particulier, l'organe de plaquage 100, 200, 250, 500 comporte au moins un élément élastiquement déformable disposé entre la structure 32, 33, 42 et le module électronique 21 de puissance. Dans l'exemple présenté en figure 1, l'élément déformable comprend un ressort 43. Dans les exemples présentés en figures 3, 4, 7 et 8 l'élément déformable comprend deux ressorts 22, 23 ; 52, 53. En particulier, les deux ressorts 22, 23 ; 52, 53 sont coaxiaux et de fréquences de résonance différentes. On obtient ainsi une plus grande stabilité du plaquage.

Le ressort 43 et les deux ressorts 22, 23 ; 52, 53, assurent la compression vers le bas du module électronique 21 de puissance pour ainsi maintenir le module électronique 21 de puissance en contact par son fond avec la surface d'appui 5 du carter du bloc de puissance.

Suivant l'invention, on s'assure ainsi que la chaleur qui se crée à l'intérieur du module électronique 21 de puissance est évacuée par le fond de celui-ci et par la surface d'appui 5 du carter du bloc de puissance. Les matériaux de la surface d'appui 5 et du fond du module électronique 21 de puissance sont de préférence choisis de manière à favoriser cet échange de chaleur.

De préférence, la structure 32, 33, 42 est solidarisée au carter 20 du bloc de puissance.

Suivant un mode de réalisation représenté aux figures 1 et 3, la structure 42, 44 est fixée au carter 20 du bloc de puissance au niveau des parois latérales 20L du carter. Les ressorts 43 ; 52, 53 sont disposés entre la ou les poutres 40, 41 du cadre 42, 44 et les modules électroniques 21 de puissance. Ces ressorts 43 ; 52, 53 viennent prendre appui contre les poutres par le dessous, c'est-à-dire par la face des poutres qui est en regard des modules électroniques 21, et presser les modules électroniques 21 vers le bas, c'est-à-dire vers la surface d'appui 5.

Suivant un autre mode de réalisation illustré à la figure 4, la solidarisation de la structure 32 au carter 20 est réalisée par une tige 24 montée dans l'axe du ressort 22, 23. Par exemple, la tige 24 est une tige de vis. Les ressorts 22, 23 s'étendent le long de la tige 24 depuis le cadre 32. La tige 24 entre en prise dans un trou de la surface d'appui 5, par exemple par un filetage de la tige 24 et du trou.

La figure 2 présente un exemple de structure ayant la forme d'un cadre 32 comprenant des vis destinées à fixer la structure 32 à la surface d'appui 5 du carter. La structure 32 comporte deux poutres longitudinales 30, 31 reliées entre elles par des poutres transversales 34. Le cadre 32 possède au moins un lamage qui permet de laisser passer la tige 24 et qui réalise une surface d'appui pour une portion plus épaisse de la tige, telle qu'une tête de vis 24a. La tige 24 peut venir en prise avec la surface d'appui 5 par l'intermédiaire d'une portion filetée 24c. Le ressort peut être monté autour d'une portion 24b de petit diamètre.

Dans une variante de ce mode de réalisation, le carter 20 comprend au moins une butée 20B au niveau des parois latérales 20L du carter 20. La structure 32 appuie sur la butée 20B, après la mise en prise de la tige 24 dans la surface d'appui 5. La butée 20B permet de contrôler la distance entre la structure 32 et le module électronique 21 de puissance, et d'améliorer la stabilité de la structure 32.

Suivant un mode de réalisation illustré en figure 7, l'organe de plaquage 250 comprend en outre une entretoise 25 dans laquelle est monté l'élément déformable 22, 23. L'entretoise 25 peut être solidaire de la structure 33 au niveau d'une de ses extrémités. Une autre extrémité comprenant une portion radiale 25R peut venir en appui sur le module 21 électronique de puissance sous l'effet de l'effort exercé par la seconde extrémité de l'élément déformable.

Dans un mode de réalisation dont un exemple est présenté en figure 3, un organe de fixation 3 assure un maintien de la position du module 21 de puissance sur la surface d'appui 5. L'organe de fixation 3 permet d'éviter des mouvements du module électronique 21 de puissance dans des directions autres que la direction de plaquage.

Par exemple, chaque module 21 de puissance comporte des pattes 10 de fixation en forme d'oreilles qui font saillie latéralement de chaque boîtier 2. Ces pattes 10 ou oreilles sont destinées à recevoir les organes de fixation 3. La fixation est assurée par exemple par vissage de chaque boîtier 2 à la surface d'appui 5 du carter.

Dans l'exemple de bloc en figure 3, des vis 3 indépendantes assurent la fixation des pattes 10 des modules électroniques 21 de puissance à la surface d'appui 5 du carter 20.

Dans les exemples de bloc en figures 4 et 7, l'organe de fixation comprend la tige de solidarisation de la structure 32 avec la surface d'appui 5. Par exemple, la tige 24 assure un maintien de la position latérale du module 21 de puissance en s'introduisant dans les oreilles 10 de chaque module électronique 21 de puissance.

Contrairement à l'exemple en figure 3 dans lequel la structure 42 est fixée au carter 20 indépendamment de la fixation des modules 21 de puissance à la surface d'appui 5, dans l'exemple en figure 4, le maintien du module 21 de puissance est réalisé avec la tige 24 de fixation de la structure 32 sur le carter 20.

Dans un mode de réalisation illustré en figures 3 et 4, au moins une carte électronique 6 de commande est disposée en vis-à-vis des modules électroniques 21 de puissance. La carte électronique 6 est électriquement connectée au module électronique 21 de puissance par des fils de liaisons électriques 12. Par exemple, la carte électronique 6 de commande délivre des signaux de commande pour contrôler les composants 16 de puissance. La carte électronique 6 de commande est par exemple une carte à circuit imprimé ou PCB (pour « printed circuit board » en anglais).

Par exemple, la structure 32, 33, 42 est destinée à supporter la carte électronique 6 de commande en vis-à-vis du module électronique 21 de puissance, notamment sur au moins une étendue de la carte 6.

De préférence, la structure 32, 33, 42 est revêtue d'un surmoulage en matière plastique pour assurer l'isolation de la carte électronique 6 de commande.

Dans un exemple présenté en figures 3 et 4, la carte électronique 6 est fixée à la structure 32, 33, 42 en y étant vissée notamment par des vis 11 respectives.

Dans un autre exemple, la carte électronique 6 de commande est fixée à la structure 32 par l'intermédiaire de la tige 24 de fixation de la structure 32 à la surface d'appui 5.

La figure 8 présente un exemple d'organe de plaquage selon un mode de réalisation. L'organe de plaquage 250 permet de plaquer une pièce contre une surface d'appui 5. La pièce est par exemple un module 21 électronique de puissance, en particulier une patte de fixation 10 du module 21 électronique.

L'organe de plaquage 250 comprend un élément élastiquement déformable tel que décrit précédemment, constitué par exemple de deux ressorts coaxiaux 22, 23.

L'organe de plaquage 250 peut comprendre une tige 24 montée dans l'axe des deux ressorts 22, 23. La tige 24 permet de réaliser la liaison mécanique entre une première extrémité des deux ressorts 22, 23 et la surface d'appui 5.

La tige 24 peut comprendre une première portion 24a de grand diamètre, une deuxième portion 24b de petit diamètre et une troisième portion 24c destinée à venir en prise avec la surface 5.

La deuxième portion 24b peut être montée dans l'axe des deux ressorts 22, 23. La première portion 24a de la tige peut venir en appui sur la première extrémité des deux ressorts 22, 23 lorsque la troisième portion 24b vient en prise avec la surface d'appui 5.

La troisième portion 24c de la tige 24 vient en prise avec la surface d'appui 5 par l'intermédiaire d'un filetage, ou par encliquetage, ou par tout autre moyen de solidarisation.

De préférence, la tige 24 traverse la pièce 10 pour venir en prise avec la surface d'appui 5. Par exemple, la pièce 10 a un trou de diamètre supérieur à une dimension transversale de la tige 24. Ainsi, un contact direct entre la tige 24 et la pièce 10 est évité. La tige 24 est donc préservée des vibrations de la pièce 10, ce qui améliore la durée de vie de l'organe de plaquage.

L'organe de plaquage 250 peut comprendre en outre une entretoise 25 dans laquelle sont montés les deux ressorts 22, 23.

De préférence, l'entretoise 25 comprend au moins portion radiale 25R s'étendant suivant une direction transverse à l'axe de l'élément déformable. La portion radiale 25R est par exemple un bord d'une extrémité de l'entretoise 25, ou une excroissance sur une paroi interne de l'entretoise 25.

Lorsque la troisième portion 24c de la tige 24 vient en prise avec la surface 5, la portion radiale 25R est prise entre la seconde extrémité de l'élément déformable et la pièce 10. La seconde extrémité de l'élément déformable exerce alors un effort sur la pièce 10 par l'intermédiaire de la portion radiale 25R. Ainsi, l'entretoise 25 est maintenue par l'élément déformable.

Enfin, à la figure 5, il est représenté un véhicule électrique comportant un onduleur 90 selon l'invention. Par exemple, l'onduleur 90 est monté entre une batterie 50 haute tension et une machine électrique 80 pour alimenter la machine électrique 80 en énergie. L'onduleur 90 comporte un bloc 1 de puissance ayant six modules électroniques 21 de puissance ; et peut comporter deux dispositifs de filtrage 60, 70 montés respectivement en amont et en aval du bloc 1.

Dans l'onduleur 90, les blocs électroniques 1 de puissance convertissent notamment un courant continu provenant de la batterie 50 en un courant alternatif pour alimenter la machine électrique 80.

L'invention n'est pas limitée aux exemples décrits. En particulier, les modes de réalisation de l'organe de plaquage peuvent être combinés les uns avec les autres. Il en est de même pour les modes de réalisation du bloc de puissance. En outre, les modes de réalisation de l'organe et du bloc peuvent être combinés entre eux.

## Revendications

1. Organe (100, 200, 250) de plaquage d'une pièce (10, 21) sur une surface (5) d'un support (20), ledit organe comprenant un élément élastiquement déformable (22, 23) s'étendant suivant un axe, ledit élément ayant
une première extrémité destinée à être en liaison mécanique avec ledit support (20), et
une seconde extrémité destinée à exercer un effort sur ladite pièce (10, 21),
ledit élément élastiquement déformable comprenant au moins un ressort (22, 23) et
l'organe de placage comprenant une tige (24) montée dans l'axe de l'élément déformable, la tige (24) étant destinée à participer à la liaison mécanique entre la première extrémité et le support (5).

2. Organe de plaquage (200, 250) suivant la revendication 1 dans lequel l'élément élastiquement déformable comprend deux ressorts (22, 23) coaxiaux de fréquences de résonance différentes.

3. Organe de plaquage (250) suivant la revendication 1 ou 2 dans lequel la tige (24) a une première portion (24a) de grand diamètre, une deuxième portion (24b) de petit diamètre et une troisième portion (24c) destinée à venir en prise avec la surface (5),
ladite deuxième portion (24b) étant montée dans l'axe de l'élément élastiquement déformable (22, 23), et
ladite première portion (24a) étant destinée à appuyer sur la première extrémité de l'élément élastiquement déformable lorsque la troisième portion (24c) vient en prise avec la surface (5).

4. Organe de plaquage (250) suivant l'une des revendications 1 à 3 comprenant en outre une entretoise (25) dans laquelle est monté l'élément déformable (22, 23),
l'entretoise (25) comprenant au moins une portion radiale (25R) s'étendant suivant une direction transverse à l'axe de l'élément déformable, ladite portion radiale (25R) étant destinée à être prise entre la seconde extrémité de l'élément déformable et la pièce (10, 21) lorsque la seconde extrémité exerce un effort sur la dite pièce (10, 21).

5. Bloc (1) de puissance comportant un carter (20) ayant une surface d'appui (5) sur laquelle repose au moins un module électronique (21) de puissance, le ou chaque module électronique (21) de puissance comportant au moins un composant électronique (16) de puissance, **caractérisé en ce qu'**il comprend
au moins un organe de plaquage (200, 250) selon l'une des revendications 1 à 4 plaquant le module de puissance sur ladite surface d'appui (5).

6. Bloc (1) de puissance suivant la revendication 5 comprenant en outre
au moins une structure (32, 33, 42) en vis-à-vis du module (21) de puissance, ladite structure (32, 33, 42) étant fixée au carter (20) du bloc de puissance, et
ladite structure (32, 33, 42) étant associée audit organe de plaquage (200, 250).

7. Bloc de puissance suivant la revendication 6, dans lequel
ladite structure (32, 33, 42) comprend au moins une poutre (30, 31 ; 40, 41) sensiblement parallèle à ladite surface d'appui (5) et fixée au carter (20), et
l'organe de plaquage (200, 250) est monté entre la poutre (30, 31 ; 40, 41) et le module électronique (21) de puissance.

8. Bloc de puissance suivant la revendication 6 ou 7, dans lequel ladite structure (32) est fixée au carter (20) au niveau de parois latérales (20L) du carter.

9. Bloc de puissance suivant la revendication 6 ou 7, dans lequel ladite structure (32) est fixée à ladite surface d'appui (5) du carter au moins par l'intermédiaire de la tige (24).

10. Bloc de puissance suivant la revendication 9, dans lequel ladite structure (32) repose sur au moins une butée (20B) située sur une paroi latérale (20L) du carter (20).

11. Bloc de puissance suivant l'une des revendications 6 à 10 lorsqu'elles dépendent de la revendication 4, dans lequel ladite entretoise (25) est solidaire avec ladite structure (33).

12. Bloc de puissance suivant l'une des revendications 6 à 11 dans lequel ladite structure (32, 42) supporte au moins une carte électronique (6) de commande en vis-à-vis du module électronique (21) de puissance.

13. Bloc de puissance suivant la revendication 12 lorsqu'elle dépend de la revendication 9 dans lequel la carte électronique (6) de commande est fixée à la structure (32) par l'intermédiaire de la tige (24).

14. Bloc de puissance suivant l'une des revendications 5 à 13, dans lequel la position du module électronique (21) de puissance sur la surface d'appui (5) est maintenue par au moins un organe de fixation (3).

15. Bloc de puissance suivant la revendication 14 dans lequel ledit organe de fixation du module électronique comprend ladite tige (24).

16. Onduleur (90) pour véhicule électrique comportant un bloc (1) suivant l'une des revendications 5 à 15.
